# EUROPEAN PATENT APPLICATION

(11) **EP 4 818 358 A1**
(43) Date of publication of application: **07.10.2026**
(21) Application number: 24895191.5
(22) Date of filing: 18.11.2024
(51) Int. Cl.: C23C 14/34, C04B 35/495

(54) **POTASSIUM SODIUM NIOBATE SINTERED BODY AND SPUTTERING TARGET FORMED OF SAID SINTERED BODY**

(30) Priority: 29.11.2023 JP 2023201197
(71) Applicant: JX Advanced Metals Corporation, Tokyo 105-8417 (JP)
(72) Inventor: MUNEYASU, Kei, Kitaibaraki-shi, Ibaraki 319-1535 (JP); NARA, Atsushi, Kitaibaraki-shi, Ibaraki 319-1535 (JP)
(74) Representative: Forresters IP LLP
(86) International application number: PCT/JP2024/040845
(87) International publication number: WO 2025/115681

(57) **Abstract**

An object of the present disclosure is to provide a dense potassium sodium niobate sintered body and a sputtering target capable of producing a thin film having a desired composition and crystal phase. Specifically provided is a potassium sodium niobate sintered body containing potassium (K), sodium (Na), niobium (Nb), and oxygen (O), having a composition satisfying 1<(K+Na)/Nb≤1.3 in an atomic ratio, and having a dimensional density of 3.9 g/cm³ or more.

## Description

### [Technical Field]

The present disclosure relates to a potassium sodium niobate sintered body and a sputtering target formed of the sintered body.

### [Background Art]

As a piezoelectric material used in sensors, actuators, and the like, lead-based PZT (lead zirconate titanate), which exhibits excellent piezoelectric properties, is being used. While PZT has favorable and stable piezoelectric properties, it contains lead and thus imposes a heavy environmental burden. In particular, in Europe, its use is restricted as a substance with a high environmental burden under the RoHS (Restriction of Hazardous Substances) Directive and the ELV (End-of Life Vehicles) Directive. Therefore, substitution with non-lead-based (lead-free) materials as piezoelectric materials has become an issue.

Although various materials have been studied as alternative substances, it is not easy to find a material that is comparable to the properties and stability of PZT, and currently, PZT continues to be used under an exemption from the RoHS Directive. Under such circumstances, potassium sodium niobate (KNN) is cited as a candidate for a lead-free PZT alternative because it is said to exhibit piezoelectric properties relatively close to those of PZT. Here, for example, Patent Document 1 discloses a piezoelectric body formed of potassium sodium niobate.

Specifically, a piezoelectric layer represented by the compositional formula (KₐNa₁₋ₐ)ₓNbO₃ (0.1<a<1, 1≤x≤1.2) is disclosed. It also describes that, as necessary, potassium or sodium may be added in excess, or other components may be added. As a method for producing the piezoelectric layer, Patent Document 1 describes that a precursor solution having the composition of the foregoing compositional formula is applied to a substrate, and annealed for crystallization to produce a piezoelectric body (sol-gel method). In addition, Patent Document 1 describes that it can be produced by an MOD method, a laser ablation method, or a sputtering method.

Patent Document 2 describes a sputtering target material capable of producing an alkali niobium oxide piezoelectric film (KNN film). In addition, Patent Document 3 discloses forming a thin film by an RF magnetron sputtering method using a sputtering target material formed of a sintered body represented by the compositional formula (K₁₋ₓNaₓ)NbO₃ (0<x<1). Specifically, a high-density potassium sodium niobate sputtering target is disclosed.

### [Prior Art Documents]

### [Patent Documents]

[Patent Document 1] Japanese Unexamined Patent Application Publication No. 2014-033210
[Patent Document 2] Japanese Unexamined Patent Application Publication No. 2019-161074
[Patent Document 3] International Publication No. 2019/167657

### [Disclosure of the Invention]

### [Problems to be Solved by the Invention]

When a thin film is formed using a potassium sodium niobate sputtering target, a problem arises in that the alkali components volatilize, thereby preventing a desired composition from being obtained, and making it impossible to obtain a sintered body having a desired density. In view of such problems, an object of the present disclosure is to provide a dense potassium sodium niobate sintered body capable of producing a thin film having a desired composition, and a sputtering target formed of the sintered body.

### [Means for Solving the Problems]

The gist of the present disclosure is as follows.
[1] A potassium sodium niobate sintered body containing potassium (K), sodium (Na), niobium (Nb), and oxygen (O), having a composition satisfying 1.0<(K+Na)/Nb≤1.3 in an atomic ratio, and having a dimensional density of 3.9 g/cm³ or more.
[2] The potassium sodium niobate sintered body according to [1] above, wherein I_{TG}/I_{BG} is 50 or more, where I_{TG} is an X-ray diffraction peak intensity attributed to a (022) plane of a (K₁₋ₓNaₓ)NbO₃(0<x<1) phase, and I_{BG} is an average value of X-ray diffraction intensities in a range of 15.0°≤2θ≤16.0°.
[3] The potassium sodium niobate sintered body according to claim 1 or 2, having a volume resistivity of 1.0 × 10⁴ Ω•cm or more and 1.0 × 10¹⁰ Ω•cm or less.
[4] A sputtering target formed of the potassium sodium niobate sintered body according to any one of [1] to [3] above.

### [Effect of the Invention]

According to the present disclosure, it is possible to provide a dense potassium sodium niobate sintered body capable of producing a thin film having a desired composition, and a sputtering target formed of the sintered body.

### [Modes for carrying out the Invention]

Specific embodiments of the present disclosure are described below, but each configuration and combinations thereof in each embodiment are merely examples, and additions, omissions, substitutions, and other modifications of the configurations can be made as appropriate without departing from the spirit of the present disclosure.

### [Potassium sodium niobate sintered body]

An embodiment of the present disclosure is a potassium sodium niobate sintered body containing potassium (K), sodium (Na), niobium (Nb), and oxygen (O). The composition of the sintered body satisfies 1.0<(K+Na)/Nb≤1.3 in an atomic ratio. In the formula, K, Na, and Nb mean the atomic ratio (at%) of each component contained in the sintered body. A conventional potassium sodium niobate sintered body contains alkali metals (potassium, sodium) and niobium at an atomic ratio of 1:1, whereas the potassium sodium niobate sintered body according to this embodiment is characterized by containing a larger amount of an alkali metal relative to niobium (alkali-rich).

When a film is formed using a conventional potassium sodium niobate sintered body containing an alkali metal and niobium at an atomic ratio of 1:1, the alkali metal components decrease, so that the result is (K+Na)/Nb<0.9 in the thin film. Consequently, the K₁₋ₓNaₓNbO₃ phase is not sufficiently crystallized, and desired piezoelectric properties could not be obtained in some cases. In this embodiment, by forming a film using a potassium sodium niobate sintered body satisfying 1<(K+Na)/Nb≤1.3, it is possible to form a thin film of 0.9≤(K+Na)/Nb≤1.1. The composition of the sintered body preferably satisfies (K+Na)/Nb≤1.2, and more preferably (K+Na)/Nb≤1.1 in an atomic ratio.

In addition, the potassium sodium niobate sintered body according to this embodiment has a dimensional density of 3.9 g/cm³ or more. When a film is formed using the sintered body, the higher the dimensional density of the sintered body, the more the generation of particles during film formation can be suppressed. In the case of a conventional potassium sodium niobate sintered body containing an alkali metal and niobium at an atomic ratio of 1:1, it was necessary to set the sintering temperature to 900°C or higher in order to improve the density. In that case, however, there was a problem in that components of the sintering apparatus suffered severe wear. However, the potassium sodium niobate sintered body of the present disclosure has improved sinterability and can achieve high densification even at a sintering temperature of less than 900°C. More preferably, the dimensional density is 4.1 g/cm³ or more.

In the potassium sodium niobate sintered body according to this embodiment, it is preferable that I_{TG}/I_{BG} is 50 or more, where I_{TG} is an X-ray diffraction peak intensity attributed to a (022) plane of a K₁₋ₓNaₓNbO₃(0<x<1) phase, and I_{BG} is an average value of X-ray diffraction intensities in a range of 15.0°≤2θ≤16.0°. The (022) plane of the K₁₋ₓNaₓNbO₃(0<x<1) phase typically shows a peak at a diffraction angle (2θ) of 45°≤2θ≤46°. If I_{TG}/I_{BG} is 50 or more, it can be said that the K₁₋ₓNaₓNbO₃ phase is sufficiently crystallized. On the other hand, if crystallization is insufficient, desired piezoelectric properties may not be obtained.

The potassium sodium niobate sintered body according to this embodiment preferably has a volume resistivity of 1 × 10⁴ Ω•cm or more and 1 × 10¹⁰ Ω•cm or less. If a sputtering target formed of the sintered body has a volume resistivity of 1 × 10⁴ Ω•cm or more, low-speed film formation by RF (Radio Frequency) sputtering becomes possible, facilitating film thickness control. More preferably, the volume resistivity is 1.0 × 10⁵ Ω•cm or more. On the other hand, if the volume resistivity exceeds 1 × 10¹⁰ Ω•cm, it becomes difficult to control the film properties by adjusting the conditions during sputtering, so 1 × 10¹⁰ Ω•cm or less is preferable. More preferably, the volume resistivity is 1 × 10⁹ Ω•cm or less.

The potassium sodium niobate sintered body according to this embodiment may contain, as a dopant, one or more of Li, which is a Group 1 element; Mg, Ca, Sr, and Ba, which are Group 2 elements; Sc, Y, La, Ce, Pr, Nd, Sm, Eu, Gd, Tb, Dy, Ho, Er, Tm, Yb, and Lu, which are rare earth elements; Cu, Mn, Ti, V, Cr, Fe, Co, Ni, Cu, Zr, Mo, Ag, Hf, Ta, and W, which are transition metal elements; Al, Zn, Ga, and In, which are amphoteric metal elements; and Si, Ge, Sn, Sb, and Bi, which are metalloid elements. The dopant can adjust the crystallinity, piezoelectric properties, and electrical properties of the piezoelectric film.

The sintered body of this embodiment can be used as a PVD (Physical Vapor Deposition) material, and can be used as, for example, a sputtering target, a vacuum deposition material, an ion plating material, and the like. When used as a sputtering target, it can be in the shape of a flat disk, a flat rectangle, or a cylinder, and can be bonded to a backing plate with a bonding material. In addition, when used as a sputtering target, its thickness can be 20 mm or less, preferably 3.0 to 15 mm, and more preferably 6.0 to 12 mm. Furthermore, the area of the surface to be sputtered is preferably 182 cm² or more.

### [Method for manufacturing potassium sodium niobate sintered body]

A method for manufacturing a potassium sodium niobate sintered body, particularly a sputtering target, according to an embodiment of the present disclosure is now explained. However, the following manufacturing conditions and the like are not limited to the disclosed ranges, and it is evident that some omissions and modifications may be made. Note that detailed descriptions of well-known manufacturing steps and processing operations will be omitted in order to avoid unnecessarily obscuring the disclosed manufacturing method.

### (Raw material powders)

As the raw material powders, Nb₂O₅ powder, K₂CO₃ powder, and Na₂CO₃ powder, or KNbO₃ powder and NaNbO₃ powder are prepared. If the particle size of the raw material powders is large, for example, if the particle size D50 (median size) is 1 mm or more, subsequent mixing and pulverizing will be difficult. Therefore, it is desirable to pulverize each raw material powder before weighing.

### (Mixing and pulverizing step)

Nb₂O₅ powder, K₂CO₃ powder, Na₂CO₃ powder, and the like are weighed so as to have a desired composition ratio (alkali-rich). After weighing, they are mixed. Note that fine pulverization and uniform mixing should be sufficiently performed using a mixer such as a ball mill or an attritor in order to obtain a dense and uniform sintered body.

### (Synthesis step)

After mixing, the mixed powder is filled into an alumina or mullite sagger and heat-treated in an air atmosphere at 700°C or higher and 900°C or less to obtain a K₁₋ₓNaₓNbO₃(0<x<1) synthetic powder having a desired composition. If the heat treatment temperature is less than 700°C, K₁₋ₓNaₓNbO₃(0<x<1) may not be obtained. On the other hand, if the heat treatment temperature is higher than 900°C, there is a high possibility that the alkali components will volatilize.

### (Pulverizing step)

After synthesis, the synthetic powder is dry-pulverized or wet-pulverized. In the case of wet pulverization, after weighing, the amount of media corresponding to the amount of raw materials is determined. The media diameter is 0.5 mm or 1.0 mm, and the media material can be alumina (Al₂O₃) or zirconia (ZrO₂). The dispersion medium is water or ethanol. When water is used, it is preferable to recover the entire amount when taking out the mixed slurry. The pulverizing method can be wet ball milling or wet bead milling, and the pulverization time can be 1 hour or longer. Using the pulverizing method described above, it is preferable to perform mixing and pulverizing until the particle diameter D50 (median diameter) becomes 2 µm or less. After wet mixing, the mixed powder is dried, and then crushed and sieved. Since the alkali components easily volatilize, there is an upper limit to the sintering temperature in the subsequent step; therefore, the density of the sintered body will not increase if the powder is not sufficiently pulverized.

### (Sintering step)

It is preferable that the mixed powder is filled into a graphite mold and subjected to hot press (H/P) sintering in an inert gas or a vacuum atmosphere. When the raw material mixing ratio is 1.0<(K+Na)/Nb<1.1, the sintering temperature is preferably 710°C or higher and 880°C or less. On the other hand, when the composition ratio of the alkali metals is 1.1≤(K+Na)/Nb≤1.3, the sintering temperature is preferably 710°C or higher and 800°C or less. If the sintering temperature is too high, the volatilization of the alkali components increases, and the degradation of the graphite mold becomes severe. On the other hand, if the sintering temperature is too low, a dense sintered body cannot be obtained. The applied pressure is preferably 200 to 400 kgf/cm². If the applied pressure is less than 100 kgf/cm², the density of the sintered body does not sufficiently increase, and if it exceeds 400 kgf/cm², the possibility of cracking during sintering increases.

### (Finishing processing)

The sintered body obtained through the sintering step described above can be processed into a desired PVD material using a processing machine such as a surface grinder, a cylindrical grinder, or a machining center, as necessary. In the case of a sputtering target, it can be formed into a flat disk shape, a rectangular shape, a cylindrical shape, or the like.

### [Examples]

The present invention is now explained based on the Examples and Comparative Examples. Note that the Examples are merely examples and the present invention is not limited by the Examples in any way. That is, the present invention is limited only by the scope of the claims and encompasses various modifications other than the Examples included in the present disclosure.

The evaluation methods used in the Examples and Comparative Examples are as follows.

### (Composition analysis)

The composition of the sintered body was analyzed using the following apparatus.
Apparatus: SPS3500DD manufactured by SII
Method: ICP-OES (High Frequency Inductively Coupled Plasma Optical Emission Spectrometry)

### (Dimensional density)

A sample of a predetermined size (about 20 × 20 × 10 mm) was cut out from the sintered body, and the length, width, and thickness were measured with a caliper to calculate the volume. In addition, the weight of the sintered body was measured with an electronic balance, and the dimensional density (g/cm³) = weight/volume was calculated.
Lower measurement limit of caliper: 0.01 mm
Lower measurement limit of electronic balance: 0.01 g

### (Volume resistivity)

A measurement sample of the sintered body (center part) was processed into a square shape, and on a surface exposed by grinding away 2 mm from the original surface, the volume resistivity was measured three times using the following apparatus, and the average value thereof was calculated.
Apparatus: High-resistance meter Hiresta-UX MCP-HT800 manufactured by Nittoseiko Analytech Co., Ltd.
System: Constant voltage application/leakage current measurement system
Method: Double ring method
Measurement temperature: Room temperature (20 to 25°C)
Applied voltage: 10 V

### (Analysis of crystal phase)

Analysis of the crystal phase was performed using the following apparatus.
Principle: X-ray diffraction method
Apparatus: SmartLab manufactured by Rigaku Corporation
Tube: Cu-Kα ray
Tube voltage: 40 kV
Current: 30 mA
Measurement method: 2θ-θ reflection method
Scan speed: 20°/min
Sampling interval: 0.02°
Measurement range (2θ): 10° to 60°
Divergence slit: 1°
Length limiting slit: 10 mm
Scattering slit: 8 mm
Receiving slit: Open state
Goniometer: Horizontal sample stage
Sample measurement location: Sputtering surface side

### (Example 1)

After weighing KNbO₃ powder, NaNbO₃ powder, K₂CO₃ powder, and Na₂CO₃ powder so that the mixing ratio would be (K+Na):Nb = 1.20:1 (atomic ratio), mixing was performed using a blade-rotation dry mixer. The rotation speed of the blade was 3000 rpm, and mixing was performed for 3 minutes. Thereafter, this mixed powder was heat-treated at 800°C to prepare a K₁₋ₓNaₓNbO₃(0<x<1) synthetic powder, and wet bead mill pulverization of the obtained synthetic powder was performed. After the wet bead mill pulverization, drying, crushing, and sieving with a 250 µm mesh were performed. Using this pulverized powder, hot press sintering was performed in an argon atmosphere under conditions of a sintering temperature of 750°C and a applied pressure of 250 kgf/cm². The obtained sintered body had a desired composition ratio of (K+Na)/Nb = 1.21. In addition, the dimensional density was 4.26 g/cm³, and the volume resistivity was 1.40 × 10⁵ Ω•cm, indicating that the desired product was obtained. The above results are shown in Table 1.

**[Table 1]**

| | Raw Material Powder | | | Sintering Conditions | | | Characteristics of Sintered Body | | | |
|---|---|---|---|---|---|---|---|---|---|---|
| | Raw Material Used | Mixing Ratio (Atomic Ratio) | Particle Size of Synthesized Powder (After Pulverization) | Sintering Method | Sintering Atmosphere | Sintering Temperature | Composition Ratio (Atomic Ratio) | Dimensional Density | Volume Resistivity | XRD Intensity |
| | | (K+Na)/Nb | D50(µm) | | | (°C) | (K+Na)/Nb | g/cm³ | Ω·cm | I_{TG}/I _{BG} |
| Example 1 | KNbO₃, NaNbO₃, K₂CO₃, Na₂CO₃ | 1.20 | 0.75 | Hot Press | Argon | 750 | 1.21 | 4.26 | 1.40×10⁵ | 127 |
| Example 2 | KNbO₃, NaNbO₃, K₂CO₃, Na₂CO₃ | 1.10 | 0.64 | Hot Press | Argon | 750 | 1.13 | 4.32 | 1.70×10⁵ | 146 |
| Example 3 | KNbO₃, NaNbO₃, K₂CO₃, Na₂CO₃ | 1.16 | 0.64 | Hot Press | Argon | 720 | 1.16 | 4.16 | 1.76×10⁶ | 135 |
| Example 4 | KNbO₃, NaNbO₃, K₂CO₃, Na₂CO₃ | 1.05 | 0.64 | Hot Press | Argon | 875 | 1.05 | 3.90 | 6.21×10⁶ | 125 |
| Comparative Example 1 | KNbO₃, NaNbO₃, K₂CO₃, Na₂CO₃ | 1.20 | 0.75 | Hot Press | Argon | 700 | 1.21 | 3.85 | 2.50×10⁶ | Not Measured |
| Comparative Example 2 | KNbO₃, NaNbO₃, K₂CO₃, Na₂CO₃ | 1.20 | 0.73 | Hot Press | Argon | 835 | 1.00 | 4.50 | 1.80×10⁶ | Not Measured |
| Comparative Example 3 | KNbO₃, NaNbO₃, K₂CO₃, Na₂CO₃ | 1.20 | 3.55 | Hot Press | Argon | 750 | 1.21 | 3.89 | 1.20×10⁶ | Not Measured |
| Comparative Example 4 | KNbO₃, NaNbO₃ | 1.00 | 0.71 | Hot Press | Argon | 950 | 1.00 | 4.51 | 3.46×10⁷ | Not Measured |
| Comparative Example 5 | KNbO₃, NaNbO₃, K₂CO₃, Na₂CO₃ | 1.00 | 0.71 | Pressureless Sintering | Air | 950 | 1.00 | 4.51 | 3.15×10¹⁰ | Not Measured |
| Comparative Example 6 | KNbO₃, NaNbO₃, K₂CO₃, Na₂CO₃ | 1.00 | 0.71 | Pressureless Sintering | Oxygen Atmosphere | 950 | 1.00 | 4.52 | 2.75×10¹¹ | Not Measured |

### (Example 2)

After weighing KNbO₃ powder, NaNbO₃ powder, K₂CO₃ powder, and Na₂CO₃ powder so that the mixing ratio would be (K+Na):Nb = 1.10:1 (atomic ratio), mixing was performed using a blade-rotation dry mixer. Thereafter, this mixed powder was heat-treated at 800°C to prepare a K₁₋ₓNaxNbO₃(0<x<1) synthetic powder, and wet bead mill pulverization of the obtained synthetic powder was performed. Similarly to Example 1, after the wet bead mill pulverization, drying, crushing, and sieving were performed. Using this pulverized powder, hot press sintering was performed in an argon atmosphere under conditions of a sintering temperature of 750°C and a applied pressure of 250 kgf/cm². As shown in Table 1, the obtained sintered body had a desired composition ratio of (K+Na)/Nb = 1.13. In addition, the dimensional density was 4.32 g/cm³, and the volume resistivity was 1.70 × 10⁵ Ω•cm, indicating that the desired product was obtained.

### (Example 3)

After weighing KNbO₃ powder, NaNbO₃ powder, K₂CO₃ powder, and Na₂CO₃ powder so that the mixing ratio would be (K+Na):Nb = 1.16:1 (atomic ratio), mixing was performed using a blade-rotation dry mixer. Thereafter, this mixed powder was heat-treated at 800°C to prepare a K₁₋ₓNaxNbO₃(0<x<1) synthetic powder, and wet bead mill pulverization of the obtained synthetic powder was performed. Similarly to Example 1, after the wet bead mill pulverization, drying, crushing, and sieving were performed. Using this pulverized powder, hot press sintering was performed in an argon atmosphere under conditions of a sintering temperature of 720°C and a applied pressure of 250 kgf/cm². As shown in Table 1, the obtained sintered body had a desired composition ratio of (K+Na)/Nb = 1.16. In addition, the dimensional density was 4.16 g/cm³, and the volume resistivity was 1.76 × 10⁶ Ω•cm, indicating that the desired product was obtained.

### (Example 4)

After weighing KNbO₃ powder, NaNbO₃ powder, K₂CO₃ powder, and Na₂CO₃ powder so that the mixing ratio would be (K+Na):Nb = 1.05:1 (atomic ratio), mixing was performed using a blade-rotation dry mixer. Thereafter, this mixed powder was heat-treated at 800°C to prepare a K₁₋ₓNaxNbO₃(0<x<1) synthetic powder, and wet bead mill pulverization of the obtained synthetic powder was performed. Similarly to Example 1, after the wet bead mill pulverization, drying, crushing, and sieving were performed. Using this pulverized powder, hot press sintering was performed in an argon atmosphere under conditions of a sintering temperature of 875°C and a applied pressure of 250 kgf/cm². As shown in Table 1, the obtained sintered body had a desired composition ratio of (K+Na)/Nb = 1.05. In addition, the dimensional density was 3.90 g/cm³, and the volume resistivity was 6.21 × 10⁶ Ω•cm, indicating that the desired product was obtained.

### (Comparative Example 1)

After weighing KNbO₃ powder, NaNbO₃ powder, K₂CO₃ powder, and Na₂CO₃ powder so that the mixing ratio would be (K+Na):Nb = 1.20:1 (atomic ratio), mixing was performed using a blade-rotation dry mixer. Thereafter, this mixed powder was heat-treated at 800°C to prepare a K₁₋ₓNaₓNbO₃(0<x<1) synthetic powder, and wet bead mill pulverization of the obtained synthetic powder was performed. Next, similarly to Example 1, after the wet bead mill pulverization, drying, crushing, and sieving were performed. Using this pulverized powder, hot press sintering was performed in an argon atmosphere under conditions of a sintering temperature of 700°C and a applied pressure of 250 kgf/cm². As shown in Table 1, the obtained sintered body had a desired composition ratio of (K+Na)/Nb = 1.21, but the dimensional density was as low as 3.85 g/cm³. This is considered to be because the sintering temperature was low.

### (Comparative Example 2)

After weighing KNbO₃ powder, NaNbO₃ powder, K₂CO₃ powder, and Na₂CO₃ powder so that the mixing ratio would be (K+Na):Nb = 1.20:1 (atomic ratio), mixing was performed using a blade-rotation dry mixer. Thereafter, this mixed powder was heat-treated at 800°C to prepare a K₁₋ₓNaₓNbO₃(0<x<1) synthetic powder, and wet bead mill pulverization of the obtained synthetic powder was performed. Next, similarly to Example 1, after the wet bead mill pulverization, drying, crushing, and sieving were performed. Using this pulverized powder, hot press sintering was performed in an argon atmosphere under conditions of a sintering temperature of 835°C and a applied pressure of 250 kgf/cm². As shown in Table 1, the obtained sintered body had (K+Na)/Nb = 1.00, and a desired composition ratio could not be obtained. This is considered to be because the sintering temperature was high relative to the composition ratio of the alkali metals, causing the alkali components to volatilize.

### (Comparative Example 3)

After weighing KNbO₃ powder, NaNbO₃ powder, K₂CO₃ powder, and Na₂CO₃ powder so that the mixing ratio would be (K+Na):Nb = 1.20:1 (atomic ratio), mixing was performed using a blade-rotation dry mixer. Thereafter, this mixed powder was heat-treated at 800°C to prepare a K₁₋ₓNaₓNbO₃(0<x<1) synthetic powder, and wet bead mill pulverization of the obtained synthetic powder was performed. Next, similarly to Example 1, after the wet bead mill pulverization, drying, crushing, and sieving were performed. Using this pulverized powder, hot press sintering was performed in an argon atmosphere under conditions of a sintering temperature of 750°C and a applied pressure of 250 kgf/cm². As shown in Table 1, the obtained sintered body had a desired composition ratio of (K+Na)/Nb = 1.21, but the dimensional density was as low as 3.89 g/cm³. This is considered to be because the particle diameter of the pulverized powder after synthesis was large, although it is also related to the sintering temperature.

### (Comparative Example 4)

After weighing KNbO₃ powder and NaNbO₃ powder so that the mixing ratio would be (K+Na):Nb = 1.00:1 (atomic ratio), mixing was performed using a blade-rotation dry mixer similarly to Example 1. Thereafter, this mixed powder was heat-treated at 800°C to prepare a K₁₋ₓNaₓNbO₃(0<x<1) synthetic powder, and wet bead mill pulverization of the obtained synthetic powder was performed. Next, similarly to Example 1, after the wet bead mill pulverization, drying, crushing, and sieving were performed. Using this pulverized powder, hot press sintering was performed in an argon atmosphere under conditions of a sintering temperature of 950°C and a applied pressure of 250 kgf/cm². As shown in Table 1, the obtained sintered body had a composition ratio of (K+Na)/Nb = 1.00. Due to the high sintering temperature, the degradation of the graphite mold becomes severe.

### (Comparative Example 5)

After weighing KNbO₃ powder, NaNbO₃ powder, K₂CO₃ powder, and Na₂CO₃ powder so that the mixing ratio would be (K+Na):Nb = 1.00:1 (atomic ratio), mixing was performed using a blade-rotation dry mixer. Thereafter, this mixed powder was heat-treated at 800°C to prepare a K₁₋ₓNaₓNbO₃(0<x<1) synthetic powder, and wet bead mill pulverization of the obtained synthetic powder was performed. Next, similarly to Example 1, after the wet bead mill pulverization, drying, crushing, and sieving were performed. Next, this pulverized powder was filled into a mold and pressed to produce a compact, and then the obtained compact was subjected to pressureless sintering in the air at a sintering temperature of 950°C. As shown in Table 1, the obtained sintered body had a high volume resistivity of 3.15 × 10¹⁰ Ω•cm.

### (Comparative Example 6)

After weighing KNbO₃ powder, NaNbO₃ powder, K₂CO₃ powder, and Na₂CO₃ powder so that the mixing ratio would be (K+Na):Nb = 1.00:1 (atomic ratio), mixing was performed using a blade-rotation dry mixer. Thereafter, this mixed powder was heat-treated at 800°C to prepare a K₁₋ₓNaₓNbO₃(0<x<1) synthetic powder, and wet bead mill pulverization of the obtained synthetic powder was performed. Next, similarly to Example 1, after the wet bead mill pulverization, drying, crushing, and sieving were performed. Next, this pulverized powder was filled into a mold and pressed to produce a compact, and then the obtained compact was subjected to pressureless sintering in an oxygen atmosphere at a sintering temperature of 950°C. As shown in Table 1, the obtained sintered body had a high volume resistivity of 2.75 × 10¹¹ Ω•cm.

### [Industrial Applicability]

According to the present disclosure, it is possible to provide a dense potassium sodium niobate sintered body capable of producing a thin film having a desired composition and crystal phase, and a sputtering target formed of the sintered body. By using the potassium sodium niobate sputtering target according to this embodiment, it is possible to form a piezoelectric element used for sensors, actuators, and the like.

## Claims

1. A potassium sodium niobate sintered body containing potassium (K), sodium (Na), niobium (Nb), and oxygen (O), having a composition satisfying 1.0<(K+Na)/Nb≤1.3 in an atomic ratio, and having a dimensional density of 3.9 g/cm³ or more.

2. The potassium sodium niobate sintered body according to claim 1, wherein I_{TG}/I_{BG} is 50 or more, where I_{TG} is an X-ray diffraction peak intensity attributed to a (022) plane of a (K₁₋ₓNaₓ)NbO₃(0<x<1) phase, and I_{BG} is an average value of X-ray diffraction intensities in a range of 15.0°≤2θ≤16.0°.

3. The potassium sodium niobate sintered body according to claim 1 or 2, having a volume resistivity of 1.0 × 10⁴ Ω•cm or more and 1.0 × 10¹⁰ Ω•cm or less.

4. A sputtering target formed of the potassium sodium niobate sintered body according to claim 1 or 2.
